# EUROPEAN PATENT SPECIFICATION

(11) **EP 1 695 398 B1**
(45) Date of publication and mention of the grant of the patent: **04.11.2009**
(21) Application number: 04810440.0
(22) Date of filing: 08.11.2004
(51) Int. Cl.: H01L 51/00

(54) **METHOD AND APPARATUS FOR FORMING PATTERNED COATED FILMS**
VERFAHREN UND VORRICHTUNG ZUR BILDUNG STRUKTURIERTER BESCHICHTETER FILME
PROCEDE ET DISPOSITIF SERVANT A CREER DES COUCHES MINCES DE REVETEMENT A MOTIFS

(30) Priority: 12.12.2003 US 735503
(43) Date of publication of application: 30.08.2006
(73) Proprietor: GENERAL ELECTRIC COMPANY, Schenectady, NY 12345 (US)
(72) Inventor: POON, Hak, Fei, Niskayuna, NY 12309 (US); COYLE, Dennis, Joseph, Clifton Park, NY 12065 (US); ROGOJEVIC, Svetlana, Niskayuna, NY 12309 (US)
(74) Representative: Illingworth-Law, William Illingworth
(86) International application number: PCT/US2004/037014
(87) International publication number: WO 2005/062399

(56) References cited:
- EP-A- 1 351 303
- WO-A-02/29912
- US-A1- 2002 158 295
- GRANLUND T ET AL: "PATTERNING OF POLYMER LIGHT-EMITTING DIODES WITH SOFT LITHOGRAPHY" ADVANCED MATERIALS, VCH VERLAGSGESELLSCHAFT, WEINHEIM, DE, vol. 12, no. 4, 17 February 2000 (2000-02-17), pages 269-273, XP000919758 ISSN: 0935-9648

## Description

### BACKGROUND OF INVENTION

This invention relates to a method of uniformly patterning an electro-luminescent layer of electro-luminescent devices.

Electro-active devices, such as organic light emitting diodes (referred hereinafter to as "OLEDs"), are widely used in organic transistors, fuel cell components, microelectronics processing, microanalytical test procedures, and in specialty electronics. One of the features of such devices is an electro-luminescent layer, formed from photo-sensitive materials, that emits light on receiving an electrical impulse. In order to facilitate miniaturization, conform to device geometry, and maximize electro-luminescent yield, the electro-luminescent layer must often be patterned to various textures, topography, and geometries.

Electro-luminescent layer patterning has been conventionally performed using stamping or laser ablation. In stamping, a pattern is imprinted upon the layer using mechanical force upon a patterned die or a stamping head, whereas in laser ablation, a patterned photomask covers the area to be patterned while the remaining area is selectively etched using a laser beam.

One problem associated with such patterning of electro-luminescent layers is that stamping leaves behind a substantial amount of material residue on the layer surface. Patterning by stamping also does not guarantee uniform, reproducible, and precise patterning over large specimens. While laser ablation may yield uniform, reproducible, and precisely patterned surfaces, the process needs high vacuum conditions, produces excessive debris around the patterned area, is expensive, and cannot be performed on large specimens or in fieldwork.

EP-1351303 discloses an organic light emitting display device for displaying selected images from a plurality of images, each with one or more desired colors and also describes a method of fabrication.

US-2002/0158295 describes an electrochemical transit device comprising a source contact, a drain contact and at least one gate electrode. The deposited layers may be structured by subtractive techniques such as scratching, scaring or scraping. Also described are displays incorporating such devices and processes for the production of such devices.

The current methods for patterning an electro-luminescent layer in electro-active devices use mechanical or laser-beam techniques that do not enable patterned surfaces to be patterned to precision in minimal turnaround times. Therefore, what is needed is an electro-active device having an electro-luminescent layer that is precisely and quickly patterned to uniform thickness. What is also needed is a method for patterning such an electro-luminescent layer that is applicable to a variety of material compositions with a variety of solvating species. What is also needed is a patterning method that is effectively independent of the processing or forming history of the electro-luminescent film.

### BRIEF SUMMARY OF THE INVENTION

The present invention meets these and other needs by providing a patterned electro-luminescent layer of substantially uniform thickness and a method and apparatus for forming patterned electro-luminescent layer of substantially uniform thickness on a continuous electroluminescent film. Different kinds of electro-luminescent layers can be patterned by this method. The invention also includes an apparatus for making an electro-luminescent layer by selectively removing at least one coating from a surface of a substrate.

According to a first aspect of the invention, there is provided a method of selectively removing at least one coating from a surface of a continuous electroluminescent film, the method comprising the steps of a) providing the electroluminescent film, the electroluminescent film having the at least one coating disposed on the surface; and b) contacting a portion of the at least one coating with a coating removing means; wherein c) said coating removing means comprises a wiping head which has solvents for solvating the electroluminescent film; and wherein said method of selectively removing at least one coating comprises d) wiping the portion with the wiping head in a direction that is tangential to the surface to remove the portion of the at least one coating from the substrate.

The least one coating may be a wet or dry coating.

The at least one coating may have been baked onto the surface of electroluminescent film.

The solvents may include at least one of water, methanol, ethanol, isopropanol, acetone, toluene xylene and combinations thereof.

According to a second aspect of the invention, there is provided an apparatus for selectively removing at least one coating from a surface of a continuous electroluminescent film, the apparatus comprising a) a means for supplying the electroluminescent film having the at least one coating; and b) a means for removing for removing a portion of the at least one coating; wherein said removing means comprises c) a wiping head, which has solvents for solvating the electroluminescent film, for removing a portion of the at least one coating, wherein the wiping head tangentially contacts the at least one coating; and wherein said apparatus comprises d) a means for collecting the electroluminescent film after removing the portion.

The solvents may include at least one of water, methanol, ethanol, isopropanol, acetone, toluene xylene and combinations thereof.

The wiping head may be moistened by injecting the solvents into the wiping head while the wiping head wipes the portion of the at least one coating.

The wiping head may comprise at least one of a sponge, an elastomer, a thermoplastic, a thermoset, a fiber mat, a porous material, polyurethane rubber, synthetic rubber, natural rubber, silicones, polydimethylsiloxane , textured materials and combinations thereof.

These and other aspects, advantages, and salient features of the present invention will become apparent from the following detailed description, the accompanying drawings, and the appended claims.

### BRIEF DESCRIPTION OF THE DRAWINGS

FIGURE 1 is a schematic view of a light source comprising a plurality of electro-luminescent devices on an optical panel;
FIGURE 2 is a cross-sectional view of an electro-luminescent device;
FIGURE 3 is a schematic view of one embodiment of an electro-luminescent device with its constituent patterns;
FIGURE 4 is a schematic view of a second embodiment of a patterned electro-luminescent device having a coated portion and uncoated portion;
FIGURE 5 is a schematic view of an embodiment for removing a portion of continuous sheet by wiping; FIGURE 6 is a schematic cross-sectional view of the contact surface of a wiping head of the present invention;
FIGURE 7A is a schematic view of a method of selectively removing at least one coating from a surface of a substrate; and
FIGURE 7B is a second schematic view of a method of selectively removing at least one coating from a surface of a substrate.

### DETAILED DESCRIPTION OF THE INVENTION

In the following description, like reference characters designate like or corresponding parts throughout the several views shown in the figures. It is also understood that terms such as "top", "bottom", "outward", "inward", and the like are words of convenience and are not to be construed as limiting terms.

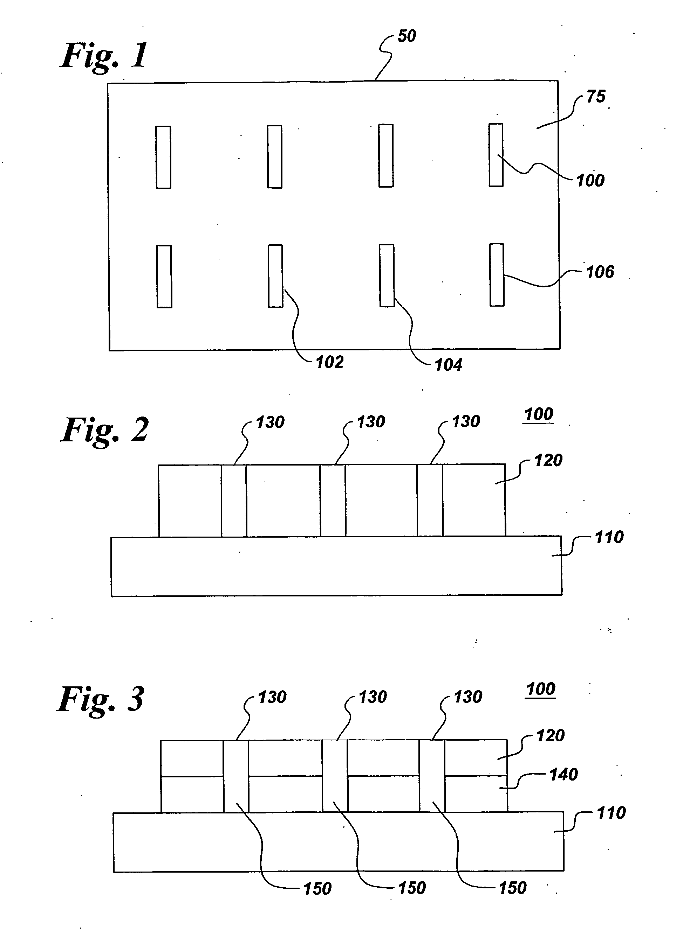

Referring to the drawings in general and to Figure 1 in particular, it will be understood that the illustrations are for the purpose of describing a preferred embodiment of the invention and are not intended to limit the invention thereto.

Visible light sources produce light in different ways. Such devices may comprise different components and mechanisms for producing light and some sources may produce light more efficiently than others. Many light sources are made of electro-luminescent materials arranged as coatings or films upon an electro-active substrate (often called an electrode). Consequently, the film may be patterned or textured to suit design requirements.

Common methods of film patterning, such as ink jet printing, deposit the coating one drop at a time, by creating polyimide wells to position the drop on the film surface. This method is commonly used in pixels for displays. Films may also be patterned or textured using methods such as, but not limited to, screen printing, gravure printing, flexographic printing, offset lithographic printing, spin coating, spray coating, meniscus coating, and dip coating. However, it is difficult to dispose and pattern coating layers of uniform thickness using such methods with subsequent solvent deposition in which the solvent creates a crater or channel upon drying. One embodiment of the present invention discloses a patterning method applicable to large area devices with coatings of uniform thickness. A common approach to producing patterned electro-luminescent film is to selectively remove portions of the electro-luminescent coating from a continuous film of the electro-luminescent material. This is conventionally done using laser ablation, plasma etching, scratching the film surface, tape lifting and lifting off under high temperature or pressure using a die or stamp. However, there are certain disadvantages associated with each of these methods. For instance, laser ablation and plasma etching focus on small working areas of the specimen, and the cost for scaling up the process can be very high. Scratching requires plowing through the continuous coating with a stiff stylus, which can potentially damage the underlying layers or substrates. Stamping and lifting with a rubbery die offer an affordable but qualitatively unacceptable solution. The liftoff process can be uniquely related to the materials of construction of the die and may result in incomplete coating removal with residues deposited on the stamped area. The residues can also affect the final properties and performance of the electro-luminescent device.

The present invention provides a process to selectively remove a portion of a continuous electro-luminescent film and to produce a sharply patterned electro-luminescent film.

The invention provides a process to remove coating material from a continuous electro-luminescent film via wiping with a 'moistened' soft head. The wiping head contains solvents that solvate (or moisten, using aqueous or non-aqueous solvents) the electro-luminescent film. A tangential wiping action using the wiping head assists in removing the solvated area.

In another embodiment, the invention also provides a solvent system that enables removal of portions of multiple layers of film in a single step. The multiple layers may either be identical or distinct from each other.

In one embodiment of the present invention, shown in Figure 1, a light source 50 comprises several different electro-luminescent devices 100, 102, 104, and 106 mounted on an optical panel 75. The electro-luminescent devices may differ from each other in geometry, processing, spatial assembly, and function. A cross-sectional view of one such electro-luminescent device 100 is schematically shown in Figure 2. Electro-luminescent device 100 includes electrode 110 and an electro-luminescent layer 120 disposed thereon. The electro-luminescent layer 120 has a first pattern 130 disposed on a surface adjacent to electrode 110. Electro-luminescent layer 120 is made from an electro-luminescent polymeric material and has a substantially uniform thickness. In another embodiment, shown in Figure 3, the electro-luminescent device 100 further comprises a conductive layer 140 disposed between the electrode 110 and the electro-luminescent layer 120. The conductive layer 140 has a second pattern 150 disposed on a surface adjacent to electro-luminescent layer 120. In yet another embodiment, the first pattern 130 is identical to the second pattern 150. Conductive layer 140 comprises at least one of poly (3,4-ethylenedioxythiophene) (also referred to hereinafter as "PEDOT"), poly (3,4-propylenedioxythiophene) (also referred to hereinafter as "PProDOT"), polystyrenesulfonate (PSS), polyvinylcarbazole (also referred to hereinafter as "PVK"), combinations thereof, and the like. Electrode 110 comprises at least one of a metal, indium tin oxide, silicon, and combinations thereof.

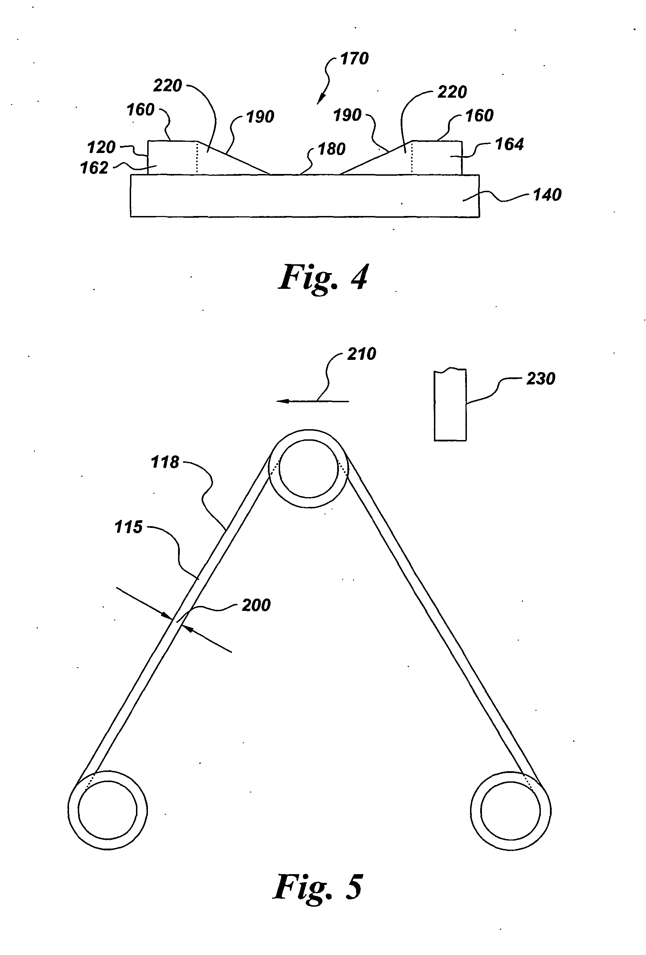

In the embodiment shown in Figure 4, electro-luminescent layer 120 is disposed on one of conductive layer 140 and comprises a first pattern 130. First pattern 130 comprises at least one coated portion 160 having a coated surface area and at least one uncoated portion 170 having an uncoated surface area, wherein the at least one uncoated portion 170 intersects the coated portion 160 to form a first coated area 162 and a second coated area 164. Coated surface area 160 is frequently greater than the uncoated surface area 170. Additionally, the uncoated portion 170 comprises at least one channel 180 that cuts through coated portion 160 such that the channel 180 has a plurality of walls 190. Each of the plurality of walls 190 has a boundary width 220 of less than 20% of the width of channel 180. Coated portion 160 has a thickness in a range from about 50 nm to about 150 nm.

The electro-luminescent layer 120 comprises a polymeric material such as, but not limited to, conjugated polymers, such as polyfluorenes, polyphenylenes (PPPs), and poly para-(phenylenevinylenes) (PPVs). The conductive layer 140 comprises at least one of poly (3,4-ethylenedioxythiophene) (commonly known as "PEDOT"), poly (3,4-propylenedioxythiophene) (also referred to herein as "PProDOT"), polystyrenesulfonate (also referred to herein as "PSS"), polyvinylcarbazole (also referred to herein as "PVK"), and combinations thereof. In other embodiments of the invention, electro-luminescent device 100 further comprises at least one additional polymer layer that performs conductive, emissive, charge injection, and charge blocking functions in the electro-luminescent device 100. Electrode 110 comprises a high work function material capable of forming ohmic contact with the upper adjacent layer (conductive layer 140). Electrode 110 comprises at least one of: indium tin oxide; tin oxide; zinc oxide; fluorinated zinc oxide; tin doped zinc oxide; cadmium tin oxide; gold; a conductive polymer comprising at least one of PEDOT, PProDOT, PSS, PVK; and combinations thereof. In other embodiments of the invention, electrode 110 is supported by a substrate material such as, but not limited to, a polycarbonate, a polyolefin, a polyester, a polyimide, a polysulfone, an acrylate, glass, metal foil, and combinations thereof.

In another embodiment of the present invention, an electro-luminescent layer 120 is disclosed for an electro-luminescent device 100. The electro-luminescent layer 120 comprises an electro-luminescent polymeric material. The electro-luminescent layer 120 is patterned and has a substantially uniform thickness 200, and is formed by forming a continuous layer 115 of the electro-luminescent polymeric material and removing a portion of the continuous layer 115 by wiping a surface 118 of the continuous layer 115 in a direction that is tangential 210 to the surface, as shown in Figure 5.

Electro-luminescent layer 120 is disposed adjacent to at least one conductive layer 140. Electro-luminescent layer 120 possesses a pattern 130 comprising at least one coated portion 160 having a coated surface area and at least one uncoated portion 170 having an uncoated surface area, wherein the at least one uncoated portion intersects the coated portion to form a first coated area 162 and a second coated area 164. Typically, the coated surface area is greater than the uncoated surface area. Additionally, the uncoated portion 170 comprises at least one channel 180 that cuts through coated portion 160 such that channel 180 has a plurality of walls 190 each of the plurality of walls 190 has a boundary width 220 of less than 20% of the width of channel 180. Coated surface area 160 has a thickness in a range from about 50 nm to about 150 nm.

In one embodiment, electro-luminescent layer 120 is made from a continuous polymer sheet 115. The continuous polymer sheet 115 is formed by depositing a polymeric film, such as PEDOT or the like, on a continuous sheet of a substrate, patterning the polymeric film, and baking the polymeric film at a temperature between about 50°C and about 200°C. The actual baking temperature depends upon the polymer substrate that is used to support the continuous polymer sheet 115. The polymeric film is then coated with an electro-luminescent material to form electro-luminescent layer 120 on the polymer film, and the electro-luminescent layer 120 is then patterned. The steps of patterning the polymeric film, patterning electro-luminescent layer 120, and baking may be performed in any sequential order. For example, application of polymeric and electro-luminescent films, patterning, and baking may proceed according to any of the sequences shown in Table 1.

**Table 1: Different, non-limiting embodiments of the present invention showing various process methods in PEDOT film application and patterning. In the table, "EL" refers to the application of electro-luminescent film.**

| **S1.** | **Step 1** | **Step 2** | **Step 3** | **Step 4** | **Step 5** | **Step 6** | **Step 7** |
|---|---|---|---|---|---|---|---|
| 1. | apply PEDOT | pattern PEDOT | dry | bake | apply EL | pattern EL | dry |
| 2. | apply PEDOT | pattern PEDOT | dry | bake | apply EL | dry | pattern EL |
| 3. | apply PEDOT | dry | pattern PEDOT | bake | apply EL | pattern EL | dry |
| 4. | apply PEDOT | dry | pattern PEDOT | bake | apply EL | dry | pattern EL |
| 5. | apply PEDOT | dry | bake | pattern PEDOT | apply EL | pattern EL | dry |
| 6. | apply PEDOT | dry | bake | pattern PEDOT | apply EL | dry | pattern EL |
| 7. | apply PEDOT | dry | bake | apply EL | pattern EL | dry | pattern PEDOT |
| 8. | apply PEDOT | dry | bake | apply EL | dry | pattern EL | pattern PEDOT |
| 9. | apply PEDOT | dry | bake | apply EL | dry | pattern EL and PEDOT simultaneously | |
| 10. | apply PEDOT | dry | apply EL | pattern EL | dry | pattern PEDOT | bake |
| 11. | apply PEDOT | dry | apply EL | dry | pattern EL | pattern PEDOT | bake |
| 12. | apply PEDOT | dry | apply EL | dry | pattern EL and PEDOT simultaneously | | bake |
| 13. | apply PEDOT | dry | apply EL | pattern EL | dry | bake | pattern PEDOT |
| 14. | apply PEDOT | dry | apply EL | dry | bake | pattern EL | pattern PEDOT |
| 15. | apply PEDOT | dry | apply EL | dry | bake | pattern EL and PEDOT simultaneously | |

To facilitate film removal over a selected area of the electro-luminescent film, a portion of the continuous polymer sheet 115 is solvated by at least one of water, methanol, ethanol, isopropanol, acetone, toluene, xylene, and combinations thereof. The surface of the solvated portion of continuous polymer sheet 115 is wiped by wiping head 230 remove a portion of at least one film, thereby patterning the film, or films. Wiping head 230 comprises at least one of a sponge, elastomer, thermoplastic, thermoset, fiber mat, porous material, polyurethane rubber, synthetic rubber, natural rubber, silicones, polydimethylsiloxane (PDMS), textured materials, and combinations thereof.

In one embodiment of the invention, the solvating species are selected for removing a single layer of film with each wiping action without damaging underlying layers. In another embodiment, the solvating species are selected to facilitate removal of multiple layers with each wiping. For example, an electro-luminescent film in a two-layer structure can be patterned using xylene as a solvent without damaging a PEDOT layer underneath. In yet another embodiment, two polymer layers can also be removed in one step with a solvent system containing water and xylene. In this particular embodiment, isopropanol is used to facilitate mixing of water and xylene to yield a homogeneous solution.

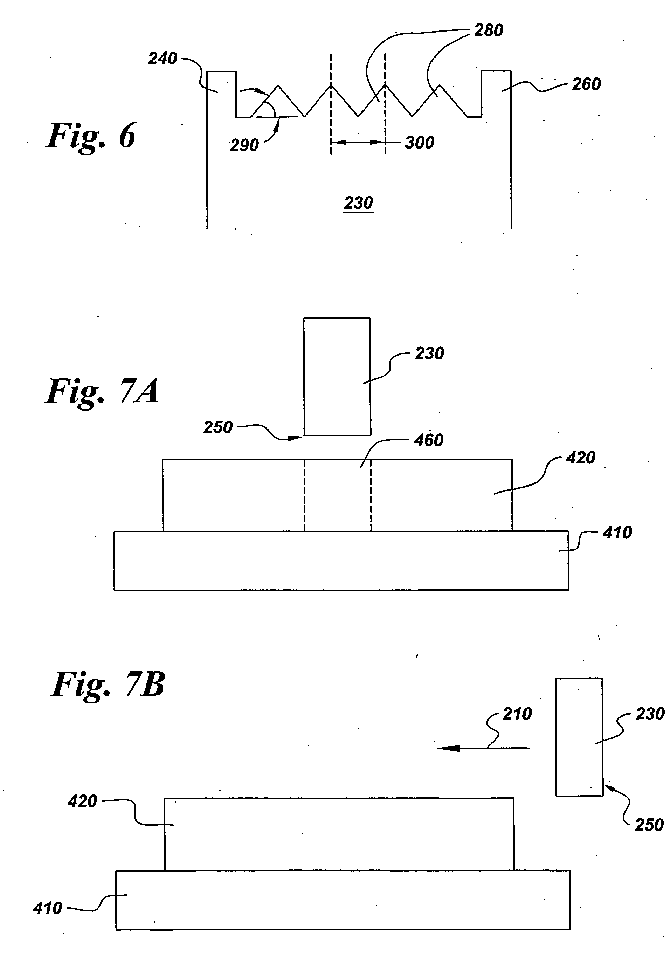

In another embodiment of the claimed invention, a method of selectively removing at least one coating from a surface of a substrate is disclosed and generally shown in Figures 7A and 7B. The method comprises the steps of: providing substrate 410 having at least one coating 420 disposed on a surface of the substrate 410; tangentially contacting a portion 460 of coating 420 with wiping head 230; and wiping the portion 460 with wiping head 230 in a direction 210 that is tangential to the surface to remove a portion of coating 420 from substrate 410. Coating 420 may be either a wet coating or a dry coating. Alternatively, coating 420 may include both wet and dry regions. In one embodiment, coating 420 is baked onto the surface of substrate 410. Wiping head 230 is at least one of a dry wiping head and a wiping head moistened with solvent 250. Solvent 250 comprises at least one of a polar solvent, a nonpolar solvent, and combinations thereof. Non-limiting examples of solvent 250 include water, methanol, ethanol, isopropanol, acetone, toluene, xylene, and combinations thereof. The choice of solvent 250 depends entirely on the coating to be removed. In one embodiment, wiping head 230 is moistened by injecting solvent 250 into the head 230 while wiping head 230 wipes portion 460 of coating 120. In another embodiment, wiping head 230 is moistened prior to wiping by at least one of dipping wiping head 230 into a bath containing solvent 250, soaking wiping head 230 in a bath containing solvent 250, spraying either wiping head 230 or portion 460 with solvent 250, or the like.

Solvent 250 may be either polar or non-polar. For each polymer coating material, there are usually three solubility parameters that account for the non-polar, polar, and hydrogen bonding strength of the polymer. Similarly, there are three corresponding solubility parameters for each solvent. The best solvent for a polymer is one having solubility parameters that match those of the polymer.

### Example 1: Removal of coating comprising of polymers having extreme solubility characteristics (i.e. co-existence of both very polar and non-polar materials).

In typical instances, the electro-luminescent layer comprises both (i) a conductive polymer coating, such as PEDOT, which is very polar and dissolves only in hydrogen-bonding solvents like water, and (ii) a light emitting polymer coating that is non-polar, which dissolves only in non-polar solvents such as toluene or xylene. In order to remove multiple polymer coatings having extremely divergent solubility characteristics in a single wipe, suitable solvents for each polymer are dispersed in a third solvent to produce a homogeneous solution. The third, or dispersing, solvent is selected from a number of solvents, such as, but not limited to, alcohols (such as isopropanol, ethanol, methanol, and the like), ketones (such as acetone, methyl ethyl ketone, and the like), acetates, ethers, methylene chloride, or any solvent having intermediate solubility parameters. The solvent ratings for a typical light-emitting plastic and PEDOT are listed in Table 1.

**Table 1: Solvent rating for polymers (1 = low solubility or insoluble; 5 = high solubility).**

| **Solvent** | **Light-emitting plastic** | **PEDOT** |
|---|---|---|
| Water | 1 | 5 |
| Methanol | 2 | 2 |
| Ethanol | 3 | 1 |
| Isopropanol | 3 | 1 |
| Acetone | 1 | 1 |
| Toluene | 5 | 1 |
| Xylene | 5 | 1 |

### Example 2: Removal of coating comprising polymers having similar solubility characteristics (i. e., with intermediate solubility parameters).

Good solvents include either one-component systems having solubility parameters that closely match the solubility parameters of the polymer film (or films), or multi-component solvent systems having effective solubility parameters that match the solubility parameters of the polymer. The solvents in the multi-component system do not necessarily have to be a good solvent for the polymer. For example, neither CCl₄ nor ethanol are good individual solvents for polymethylmethacrylate (PMMA), but a binary mixture of CCl₄ and ethanol is a good solvent for PMMA because the effective solubility parameter of the mixture matches that of PMMA.

### Example 3: Wiping Example - Selective removal of top coating without damaging underlying layer.

In this example, a PEDOT layer is spin coated onto an indium tin oxide (ITO) coated glass substrate and baked at 200°C for 1 hour. A layer of light emitting plastic (i.e., electro-luminescent layer) is then spin-coated on top of the PEDOT layer. The patterned area is wiped by solvent assisted wiping (SAW) in which xylene was the only solvent used to remove portions of the electro-luminescent layer.

### Example 4: Wiping Example - Simultaneous removal of both coating layers

The PEDOT layer is spin coated onto an indium tin oxide (ITO) coated glass substrate and baked at 200°C for 1 hour. A layer of light emitting plastic (or electro-luminescent layer) is spin-coated on top of the PEDOT layer. The patterned area is wiped by solvent assisted wiping (SAW) with a solvent mixture consisting of water, isopropanol, and xylene so as to remove both PEDOT and electro-luminescent layers.

Wiping head 230 comprises at least one of a sponge, an elastomer, a thermoplastic, a thermoset, a fiber mat, a porous material, polyurethane rubber, synthetic rubber, natural rubber, silicones, PDMS, textured materials, and combinations thereof. In one embodiment of the invention, wiping head 230 is a fixed head. In another embodiment, wiping head 230 is movable with respect to substrate 110. Alternatively, wiping head 230 and substrate 110 may be moved simultaneously with respect to each other. In still another embodiment, wiping head 230 is rotatable. In a further embodiment, wiping head 230 is a rotatable wheel.

The step of tangentially contacting a portion 460 (Figure 7B) of the at least one coating 420 with wiping head 230 comprises contacting a portion 460 of the at least one coating 420 in a tangential direction 210 with a contact surface of wiping head 230. A schematic cross-sectional view of the contact surface of wiping head 230 is shown in Figure 6. In one embodiment, shown in Figure 6, the contact surface 240 has a predetermined structure, or geometry. In one embodiment, the predetermined structure comprises at least one prism 280, with the at least one prism 280 having a predetermined angle 290. The at least one prism 280 has a geometric profile, such as a pointed profile or tip, a square profile, a trapezoidal profile, a rounded profile or tip, and the like. In another embodiment, the predetermined geometry comprises a plurality of prisms 280, wherein the plurality of prisms 280 are separated from each other by a predetermined pitch 300, as shown in Figure 6. The plurality of prism may include prisms having the same profile, or prisms having different profiles, arranged in either a random or predetermined regular order. In one embodiment, pitch 300 is about 50 microns. Wiping head 230 has a structure comprising a plurality of protrusions, such as, for example, plurality of prisms 280, to apply concentrated force to portion 460 so as to remove portion 460 and pattern the film. Wiping head protrusions are separated by indentations for carrying solvent to the film surface. The film surface is either moistened or premoistened by solvent in the liquid phase. In another embodiment, the film surface is moistened or premoistened by solvent in the vapor phase.

In one embodiment of the claimed method, the contact surface further includes at least one sidewall 260 disposed on at least one edge of the contact surface 240. In another embodiment, the method further includes the step of premoistening portion 460 (Figure 7A) prior to wiping portion 460 with wiping head 230. The step of wiping the portion 460 with the wiping head to remove the portion 460 of the at least one coating 420 from the substrate 410 (Figure 7A) comprises translating the substrate 410 in a predetermined direction with respect to wiping head 230. In another embodiment, wiping head 230 wipes the portion 460 in a direction parallel to the predetermined direction. In another embodiment, wiping head 230 wipes the portion 460 in a direction other than parallel to the predetermined direction. In another embodiment, the step of providing the substrate 410 comprises providing a continuous sheet of the substrate from a supply roll. In another embodiment the method further includes the step of collecting the continuous sheet on a take-up roll.

In another embodiment of the claimed invention, an apparatus is disclosed for selectively removing a portion 460 at least one coating 420 from a surface of a substrate 410. The apparatus comprises a means for supplying the substrate 410 having the at least one coating 420, a wiping head 230 for removing a portion 460 of the at least one coating 420, wherein the wiping head 230 contacts the at least one coating 420 in a tangential direction 210, and a means for collecting the substrate after removing the portion 460.

In another embodiment of the claimed invention, a wiping head 230 is disclosed for removing a portion 460 of at least one coating 420 disposed on a surface of a substrate 410. The wiping head 230 comprises a contact surface 240 for contacting and removing portion 460, wherein contact surface 240 contacts portion 460 in a tangential direction 210, and wherein contact surface 240 has a predetermined structure.

Although the examples described hereinabove are for an electroluminescent device, it is understood that the invention can be used in manufacturing features of other articles and devices, such as, but not limited to, microelectronic devices, photovoltaics, thin film transistors, electronic paper and displays, photonic devices, waveguides; microelectromechanical systems (MEMS), microfluidics devices, and the like.

## Claims

1. A method of selectively removing at least one coating (420) from a surface of a continuous electroluminescent film (410), the method comprising the steps of:
a) providing the electroluminescent film (410), the electroluminescent film (410) having the at least one coating (420) disposed on the surface;
b) contacting a portion (460) of the at least one coating (420) with a coating removing means (230); and
**characterized in that**
c) said coating removing means comprises a wiping head (230) which has solvents for solvating the electroluminescent film;
and further **in that** said method of selectively removing at least one coating (420) comprises:
d) wiping the portion with the wiping head (230) in a direction that is tangential (210) to the surface to remove the portion (460) of the at least one coating (420) from the electroluminescent film(410).

2. The method of claim 1, wherein the at least one coating is a wet coating.

3. The method of claim 1, wherein the at least one coating is a dry coating.

4. The method of claim 1, wherein the at least one coating is has been baked onto the surface of electroluminescent film.

5. The method of any preceding claim wherein the solvents include at least one of water, methanol, ethanol, isopropanol, acetone, toluene xylene and combinations thereof.

6. An apparatus for selectively removing at least one coating (420) from a surface of a continuous electroluminescent film (410), the apparatus comprising:
a) a means for supplying the electroluminescent film (410) having the at least one coating (420);
b) a means for removing for removing a portion (460) of the at least one coating (420);
**characterized in that** said removing means comprises
c) a wiping head (230), which has solvents for solvating the electroluminescent film, for removing a portion (460) of the at least one coating (420), wherein the wiping head tangentially (210) contacts the at least one coating (420);
and further **in that** said apparatus comprises
d) a means for collecting the electroluminescent film (410) after removing the portion.

7. The apparatus of claim 6, wherein the solvents include at least one of water, methanol, ethanol, isopropanol, acetone, toluene xylene and combinations thereof.

8. The apparatus of claim 6 or 7, wherein the wiping head is moistened by injecting the solvents into the wiping head while the wiping head wipes the portion of the at least one coating.

9. The apparatus of claim 6, 7 or 8, wherein the wiping head comprises at least one of a sponge, an elastomer, a thermoplastic, a thermoset, a fiber mat, a porous material, polyurethane rubber, synthetic rubber, natural rubber, silicones, polydimethylsiloxane , textured materials and combinations thereof.

## Patentansprüche

1. Verfahren zum selektiven Entfernen mindestens eines Überzuges (420) von einer Oberfläche eines kontinuierlichen elektrolumineszenten Films (410), wobei das Verfahren umfasst:
a) Bereitstellen des elektrolumineszenten Films (410), wobei der elektrolumineszente Film (410) mindestens einen Überzug (420) aufweist, der auf der Oberfläche angeordnet ist;
b) Kontaktieren eines Abschnittes (460) des mindestens eines Überzuges (420) mit einem Überzug entfernenden Mittel (230);
**dadurch gekennzeichnet, dass**
c) das Überzug entfernende Mittel einen Wischkopf (230) umfasst, der Lösungsmittel zum Solvatisieren des elektrolumineszenten Films aufweist
und weiter dass das Verfahren zum selektiven Entfernen mindestens eines Überzuges (420) umfasst:
d) Wischen des Abschnittes mit dem Wischkopf (230) in einer Richtung tangential (210) zu der Oberfläche, um den Abschnitt (460) des mindestens einen Überzuges (420) von dem elektrolumineszenten Film (410) zu entfernen.

2. Verfahren nach Anspruch 1, worin der mindestens eine Überzug ein nasser Überzug ist.

3. Verfahren nach Anspruch 1, worin der mindestens eine Überzug ein trockener Überzug ist.

4. Verfahren nach Anspruch 1, worin der mindestens eine Überzug auf die Oberfläche des elektrolumineszenten Filmes gebrannt wurde.

5. Verfahren nach irgendeinem vorhergehenden Anspruch, worin die Lösungsmittel mindestens eines von Wasser, Methanol, Ethanol, Isopropanol, Aceton, Toluol, Xylol und Kombinationen davon einschliessen.

6. Vorrichtung zum selektiven Entfernen mindestens eines Überzuges (420) von einer Oberfläche eines kontinuierlichen elektrolumineszenten Films (410), wobei die Vorrichtung umfasst:
a) eine Einrichtung zum Liefern des elektrolumineszenten Films (410), der den mindestens einen Überzug (420) aufweist;
b) eine Einrichtung zum Entfernen eines Abschnittes (460) des mindestens eines Überzuges (420);
**dadurch gekennzeichnet, dass** die Einrichtung zum Entfernen umfasst
c) einen Wischkopf (230), der Lösungsmittel zum Solvatisieren des elektrolumineszenten Films, zum Entfernen eines Abschnittes (460) des mindestens eines Überzuges (420) aufweist, wobei der Wischkopf den mindestens einen Überzug (420) tangential (210) kontaktiert,
und weiter dass die Vorrichtung umfasst:
d) eine Einrichtung zum Sammeln des elektrolumineszenten Films (410) nach dem Entfernen des Abschnittes.

7. Vorrichtung nach Anspruch 6, worin die Lösungsmittel mindestens eines von Wasser, Methanol, Ethanol, Isopropanol, Aceton, Toluol, Xylol und Kombinationen davon einschliessen.

8. Vorrichtung nach Anspruch 6 oder 7, worin der Wischkopf durch Injizieren der Lösungsmittel in den Wischkopf angefeuchtet wird, während der Wischkopf den Abschnitt des mindestens eine Überzuges wischt.

9. Vorrichtung nach Anspruch 6, 7 oder 8, worin der Wischkopf mindestens eines von einem Schwamm, einem Elastomer, einem thermoplastischen Material, einem wärmegehärteten Material, einer Fasermatte, einem porösen Material, Polyurethankautschuk, synthetischem Kautschuk, Naturkautschuk, Siliconen, Polydimethylsiloxan, texturierten Materialien und Kombinationen davon umfasst.

## Revendications

1. Procédé d'élimination sélective d'au moins un revêtement (420) sur une surface d'un film électroluminescent continu (410), le procédé comprenant les étapes de :
a) formation du film électroluminescent (410), ledit au moins un revêtement (420) étant disposés sur la surface du film électroluminescent (410) ;
b) mise en contact d'une partie (460) dudit au moins un revêtement (420) avec un moyen d'élimination de revêtement (230) ; et
**caractérisé en ce que**
c) ledit moyen d'élimination de revêtement comprend une tête d'essuyage (230) qui comporte des solvants destinés à dissoudre le film électroluminescent ;
et, en outre, **en ce que** ledit procédé d'élimination sélective d'au moins un revêtement (420) comprend :
d) l'essuyage de la partie avec la tête d'essuyage (230) dans une direction qui est tangentielle (210) à la surface afin d'éliminer la partie (460) dudit au moins un revêtement (420) du film électroluminescent (410).

2. Procédé selon la revendication 1, dans lequel ledit au moins un revêtement est un revêtement humide.

3. Procédé selon la revendication 1, dans lequel ledit au moins un revêtement est un revêtement sec.

4. Procédé selon la revendication 1, dans lequel le ou les revêtements ont été étuvés sur la surface du film électroluminescent.

5. Procédé selon l'une quelconque des revendications précédentes, dans lequel les solvants comportent au moins l'un de l'eau, du méthanol, de l'éthanol, de l'isopropanol, de l'acétone, du toluène, du xylène et de mélanges de ceux-ci.

6. Dispositif d'élimination sélective d'au moins un revêtement (420) sur une surface d'un film électroluminescent continu (410), le dispositif comprenant :
a) un moyen destiné à délivrer le film électroluminescent (410) comportant le ou les revêtements (420) ;
b) un moyen d'élimination destiné à éliminer une partie (460) du ou des revêtements (420) ;
**caractérisé en ce que** ledit moyen d'élimination comprend :
c) une tête d'essuyage (230), qui comporte des solvants destinés à dissoudre le film électroluminescent, afin d'éliminer une partie (460) du ou des revêtements (420), dans lequel la tête d'essuyage vient tangentiellement en contact (210) avec le ou les revêtements (420) ;
et, en outre, **en ce que** ledit dispositif comprend
d) un moyen de collecte du film électroluminescent (410) après élimination de la partie.

7. Dispositif selon la revendication 6, dans lequel les solvants comportent au moins l'un de l'eau, du méthanol, de l'éthanol, de l'isopropanol, de l'acétone, du toluène, du xylène et de mélanges de ceux-ci.

8. Dispositif selon la revendication 6 ou 7, dans lequel la tête d'essuyage est humidifiée par injection des solvants dans la tête d'essuyage pendant que la tête d'essuyage essuie la partie du ou des revêtements.

9. Dispositif selon la revendication 6, 7 ou 8, dans lequel la tête d'essuyage comprend au moins l'un d'une éponge, d'un élastomère, d'un thermoplastique, d'un thermodurcissable, d'un coussin de fibre, d'un matériau poreux, d'un caoutchouc de polyuréthanne, d'un caoutchouc synthétique, d'un caoutchouc naturel, de silicones, de polydiméthylsiloxane, de matériaux présentant une texture et de mélanges de ceux-ci.
